# EUROPÄISCHE PATENTANMELDUNG

(11) **EP 4 187 653 A1**
(43) Veröffentlichungstag der Anmeldung: **31.05.2023**
(21) Anmeldenummer: 22204286.3
(22) Anmeldetag: 28.10.2022
(51) Int. Cl.: H01M 8/04089, H01M 8/04119, H01M 8/04313, C25B 15/023, H01M 8/12

(54) **TESTSYSTEM, LUFTGEMISCHLEITUNG UND GASKONTROLLEINHEIT**

(30) Priorität: 23.11.2021 DE 102021213143
(71) Anmelder: Robert Bosch GmbH, 70442 Stuttgart (DE)
(72) Erfinder: Njodzefon, Jean-Claude, 71272 Renningen (DE); Wagner, Petra, 71069 Sindelfingen (DE); Hupfer, Thomas, 71263 Weil Der Stadt (DE); Widmann, Kevin, 71334 Waiblingen (DE)

(57) **Zusammenfassung**

Die Erfindung geht aus von einem Testsystem (10a; 10b) zu einem Charakterisieren von Festoxidzellen, bevorzugt bei Temperaturen ab 500°C bis 850°C, mit zumindest einer Gaskontrolleinheit (12a; 12b) zu einem Ausbilden eines einheitlichen Brenngasgemischs für die Festoxidzellen, mit zumindest einer Brenngasgemischleitung (16a; 16b), mit zumindest einer Wasserstoffgasleitung (18a; 18b), und insbesondere mit zumindest einer Sauerstoffgasleitung (20a; 20b), wobei die zumindest eine Gaskontrolleinheit (12a; 12b) zumindest drei Stapelschichten (22a; 22b), zumindest eine Hydrationseinheit (24a; 24b), die zu einer Befeuchtung des einheitlichen Gasgemischs direkt gasleitend mit der zumindest einen Wasserstoffgasleitung (18a; 18b) und/oder mit der zumindest einen Sauerstoffgasleitung (20a; 20b) verbunden ist und die in einer Hydrationsschicht (26a; 26b) der zumindest drei Stapelschichten (22a; 22b) angeordnet ist, zumindest eine direkt gasleitend mit der Brenngasgemischleitung (16a; 16b) und der Hydrationseinheit (24a; 24b) verbundene Mischkammer (28a; 28b), die zu einem Ausbilden des einheitlichen Gasgemischs ausgebildet ist und die in einer Mischschicht (30a; 30b) der zumindest drei Stapelschichten (22a; 22b) angeordnet ist, und zumindest eine Teststation (32a, 36a, 38a, 38a'; 32b, 36b, 38b, 38b') für eine Festoxidzelle, welche an einer Testschicht (34a; 34b) der zumindest drei Stapelschichten (22a; 22b) angeordnet ist, aufweist.

Es wird vorgeschlagen, dass die Gaskontrolleinheit (12a; 12b) zumindest eine weitere Teststation (32a, 36a, 38a, 38a'; 32b, 36b, 38b, 38b') für zumindest eine weitere Festoxidzelle aufweist, welche an der Testschicht (34a; 34b) angeordnet ist.

## Beschreibung

### Stand der Technik

Es ist bereits ein Testsystem zu einem Charakterisieren von Festoxidzellen, bevorzugt bei Temperaturen ab 500°C bis 850°C, mit zumindest einer Gaskontrolleinheit zu einem Ausbilden eines einheitlichen Brenngasgemischs für die Festoxidzellen, mit zumindest einer Brenngasgemischleitung, mit zumindest einer Wasserstoffgasleitung, und insbesondere mit zumindest einer Sauerstoffgasleitung, wobei die zumindest eine Gaskontrolleinheit zumindest drei Stapelschichten, zumindest eine Hydrationseinheit, die zu einer Befeuchtung des einheitlichen Gasgemischs ausgebildet ist, die insbesondere direkt gasleitend mit der zumindest einen Wasserstoffgasleitung und/oder mit der zumindest einen Sauerstoffgasleitung verbunden ist, und die in einer Hydrationsschicht der zumindest drei Stapelschichten angeordnet ist, zumindest eine direkt gasleitend mit der Brenngasgemischleitung und der Hydrationseinheit verbundene Mischkammer, die zu einem Ausbilden des einheitlichen Gasgemischs ausgebildet ist und die in einer Mischschicht der zumindest drei Stapelschichten angeordnet ist, und zumindest eine Teststation für eine Festoxidzelle, welche an einer Testschicht der zumindest drei Stapelschichten angeordnet ist, aufweist, vorgeschlagen worden.

### Offenbarung der Erfindung

Die Erfindung geht aus von einem Testsystem zu einem Charakterisieren von Festoxidzellen, bevorzugt bei Temperaturen ab 500°C bis 850°C, mit zumindest einer Gaskontrolleinheit zu einem Ausbilden eines einheitlichen Brenngasgemischs für die Festoxidzellen, mit zumindest einer Brenngasgemischleitung, mit zumindest einer Wasserstoffgasleitung, und insbesondere mit zumindest einer Sauerstoffgasleitung, wobei die zumindest eine Gaskontrolleinheit zumindest drei Stapelschichten, zumindest eine Hydrationseinheit, die zu einer Befeuchtung des einheitlichen Gasgemischs ausgebildet ist, die insbesondere direkt gasleitend mit der zumindest einen Wasserstoffgasleitung und/oder mit der zumindest einen Sauerstoffgasleitung verbunden ist, und die in einer Hydrationsschicht der zumindest drei Stapelschichten angeordnet ist, zumindest eine direkt gasleitend mit der Brenngasgemischleitung und der Hydrationseinheit verbundene Mischkammer, die zu einem Ausbilden des einheitlichen Gasgemischs ausgebildet ist und die in einer Mischschicht der zumindest drei Stapelschichten angeordnet ist, und zumindest eine Teststation für eine Festoxidzelle, welche an einer Testschicht der zumindest drei Stapelschichten angeordnet ist, aufweist.

Es wird vorgeschlagen, dass die Gaskontrolleinheit zumindest eine weitere Teststation für zumindest eine weitere Festoxidzelle aufweist, welche an der Testschicht angeordnet ist.

Vorzugsweise ist das Testsystem zu einem, insbesondere gleichzeitigen und/oder zeitlich versetzten, Charakterisieren von gleichartigen und von verschiedenartigen Festoxidzellen ausgebildet, wobei insbesondere zumindest zwei Festoxidzellen gleichzeitig in dem Testsystem aufgenommen werden können. Einzelne oder alle der Festoxidzellen können dabei beispielsweise als anodengestützte, metallgestützte, kathodengestützte und/oder elektrolytgestützte Festoxidzellen ausgebildet sein. Vorzugsweise ist das Testsystem zu einem Charakterisieren von zumindest zwei Festoxidzellen gleichzeitig ausgebildet. Eine Festoxidzelle kann beispielsweise als Festoxidbrennstoffzelle oder Festoxidelektrolysezelle ausgebildet sein. Die Festoxidzelle ist bevorzugt zu einem Konvertieren von chemischer Energie, insbesondere eines Brenngases, wie beispielsweise eines Erdgases, in elektrische Energie, bevorzugt bei Temperaturen von 450°C bis 850°C, besonders bevorzugt bei Temperaturen ab 500°C bis 850°C ausgebildet. Bevorzugt weisen die Festoxidzellen, insbesondere zumindest eine Festoxidzelle, einen gasdichten und für Sauerstoffionen durchlässigen Elektrolyten auf. Bevorzugt weisen die Festoxidzellen, insbesondere zumindest eine Festoxidzelle, zumindest eine mehrschichtige Elektrode, insbesondere Anode und/oder Kathode, auf. Bevorzugt ist das Testsystem zu einem Charakterisieren von Festoxidzellen in einer Temperaturspanne von 500°C bis 850°C ausgebildet. Insbesondere kann das Testsystem zu einem Charakterisieren von Festoxidzellen in einer Temperaturspanne von 650°C bis 850°C frei von einem Katalysator ausgebildet sein.

Das Testsystem kann zumindest eine Gaszufuhreinheit umfassen. Der Gaszufuhreinheit können die zumindest eine Brenngasgemischleitung, die zumindest eine Wasserstoffgasleitung und/oder die zumindest eine Sauerstoffgasleitung zugeordnet sein. Bevorzugt ist die Brenngasgemischleitung zu einem Zuführen von einem Brenngasgemisch mit Kohlenstoffmonoxid-, Kohlenstoffdioxid-, Methan-, Wasserdampf-, Wasserstoff-, Stickstoff-, Methanol-, Dieselreformat- und/oder Argon-Anteilen zu der Gaskontrolleinheit, insbesondere zu der Mischkammer, ausgebildet. Vorzugsweise ist die Brenngasgemischleitung zu einem Zuführen von einem Brenngasgemisch mit zumindest Kohlenstoffmonoxid-, zumindest Kohlenstoffdioxid- und zumindest Methan-Anteilen, insbesondere mit Wasserdampf, zu der Gaskontrolleinheit, insbesondere zu der Mischkammer, ausgebildet. Bevorzugt ist die Wasserstoffgasleitung zu einem Zuführen von Wasserstoff, insbesondere mit Wasserdampf, zu der Gaskontrolleinheit, bevorzugt zu der Hydrationseinheit und/oder insbesondere zu der Mischkammer, ausgebildet. Bevorzugt ist die Sauerstoffgasleitung zu einem Zuführen von Sauerstoff, insbesondere mit Wasserdampf, zu der Gaskontrolleinheit, bevorzugt zu der Hydrationseinheit und/oder insbesondere zu der Mischkammer, ausgebildet.

Bevorzugt ist die Gaskontrolleinheit aus einer Keramik, bevorzugt einer Vollkeramik, insbesondere einer Oxidkeramik, wie beispielsweise bevorzugt Aluminiumoxid oder auch Siliziumnitrid, Aluminiumnitrid, Zirkonoxid und/oder Siliziumcarbid, ausgebildet. Insbesondere sind die Stapelschichten der Gaskontrolleinheit bevorzugt aus einer Keramik, insbesondere einer Oxidkeramik, wie beispielsweise bevorzugt Aluminiumoxid oder auch Siliziumnitrid, Aluminiumnitrid, Zirkonoxid und/oder Siliziumcarbid, ausgebildet.

Die Hydrationseinheit kann zumindest einen Bubbler, insbesondere zumindest einen Dampfdrucksättiger, zumindest einen Verdampfer oder zumindest eine Reaktionskammer umfassen. Der zumindest eine Verdampfer und/oder der zumindest eine Bubbler können in zumindest eine der zumindest einen Brenngasgemischleitung, der zumindest einen Wasserstoffgasleitung und/oder der zumindest einen Sauerstoffgasleitung integriert ausgebildet sein. Bevorzugt weist die Hydrationseinheit zumindest eine Reaktionskammer auf, insbesondere zu einer Reaktion von Wasserstoff und Sauerstoff. Bevorzugt ist die Hydrationseinheit, insbesondere die Reaktionskammer, direkt gasleitend mit der zumindest einen Wasserstoffgasleitung und mit der zumindest einen Sauerstoffgasleitung verbunden. Bevorzugt ist die Hydrationseinheit, insbesondere die Reaktionskammer, direkt gasleitend mit der Mischkammer verbunden, insbesondere an einer anderen Seite als die zumindest eine Wasserstoffgasleitung und/oder die zumindest einen Sauerstoffgasleitung mit der Hydrationseinheit, insbesondere der Reaktionskammer, verbunden ist/sind. Bevorzugt umfasst die Hydrationseinheit zumindest einen Katalysator, bevorzugt zumindest einen Edelmetallkatalysator. Bevorzugt ist der zumindest eine Katalysator in der zumindest einen Reaktionskammer angeordnet zu einem Katalysieren der Reaktion von Wasserstoff und Sauerstoff. Bevorzugt ist die Hydrationseinheit in der Gaskontrolleinheit angeordnet. Bevorzugt ist die Hydrationseinheit in genau einer Stapelschicht, insbesondere der Hydrationsschicht, der Gaskontrolleinheit angeordnet. Bevorzugt ist die Hydrationsschicht verschieden von der Mischschicht ausgebildet. Bevorzugt ist die Hydrationsschicht verschieden von der Testschicht ausgebildet. Bevorzugt sind die Hydrationsschicht und die Mischschicht direkt benachbarte Stapelschichten der Gaskontrolleinheit. Bevorzugt ist die Hydrationsschicht auf einer der Testschicht abgewandten Seite der Mischschicht angeordnet. Bevorzugt bildet die Testschicht eine vorletzte Schicht der Gaskontrolleinheit in Stapelrichtung, insbesondere auf einer Testseite der Mischschicht. Bevorzugt ist die Stapelrichtung zumindest im Wesentlichen senkrecht zu größten Außenflächen der einzelnen Stapelschichten ausgerichtet. Der Ausdruck "im Wesentlichen senkrecht" soll hier insbesondere eine Ausrichtung einer Richtung relativ zu einer Bezugsrichtung definieren, wobei die Richtung und die Bezugsrichtung, insbesondere in einer Projektionsebene betrachtet, einen Winkel von 90° einschließen und der Winkel eine maximale Abweichung von insbesondere kleiner als 8°, vorteilhaft kleiner als 5° und besonders vorteilhaft kleiner als 2° aufweist. Bevorzugt bildet die Hydrationsschicht eine vorletzte Schicht der Gaskontrolleinheit in Stapelrichtung, insbesondere auf einer Hydrationsseite der Mischschicht. Bevorzugt ist die Mischschicht zwischen der Hydrationsschicht und der Testschicht angeordnet. Bevorzugt ist die Hydrationseinheit in Bezug auf einen Gasfluss von der zumindest einen Brenngasgemischleitung, der zumindest einen Wasserstoffgasleitung und/oder der zumindest einen Sauerstoffgasleitung zu der Mischkammer vor der Mischkammer angeordnet, insbesondere mit zumindest einer der zumindest einen Wasserstoffgasleitung und/oder der zumindest einen Sauerstoffgasleitung verbunden und/oder in zumindest eine der zumindest einen Wasserstoffgasleitung und/oder der zumindest einen Sauerstoffgasleitung integriert. Bevorzugt sind die Testschicht und die Mischschicht durch mindestens eine Stapelschicht voneinander beabstandet angeordnet. Bevorzugt sind jeweils benachbarte Stapelschichten miteinander verbunden. Einzelne Stapelschichten können durch mindestens 2 mm, bevorzugt mindestens 5 mm, breite Streifen, insbesondere innerhalb eines durch die Streifen, bevorzugt Goldstreifen, oder beispielsweise Glimmerstreifen, Glasstreifen und/oder Glaskeramikstreifen, definierten Dichtungsbereichs gasdicht, miteinander verbunden sein. Einzelne Stapelschichten können durch, bevorzugt 100-500 µm starke, Streifen, bevorzugt Goldstreifen, oder beispielsweise Glimmerstreifen, Glasstreifen und/oder Glaskeramikstreifen, insbesondere innerhalb eines durch die Streifen definierten Dichtungsbereichs gasdicht, miteinander verbunden sein.

Durch die erfindungsgemäße Ausgestaltung des Testsystems kann ein vorteilhaft gleichmäßiges Brenngasgemisch erreicht werden zu einem gleichmäßigen Charakterisieren von zumindest zwei Festoxidzellen gleichzeitig unter gleichen Bedingungen. Insbesondere können Datensätze zu Charakteristika der Festoxidzellen schneller und einheitlicher gemessen werden. Es können vorteilhaft verlässliche Datensätze erreicht werden, insbesondere für Festoxidzellen, welche unter vorteilhaft gleichen Bedingungen gemessen wurden. Insbesondere können vorteilhaft gleichmäßige Testbedingungen erreicht werden, welche vorteilhaft vergleichbare Datensätze zu Festoxidzellen ermöglichen. Es kann ein vorteilhaft einheitlich befeuchtetes Brenngasgemisch erreicht werden. Es kann ein vorteilhafter Umweltstandard durch simultane Messung mehrerer Festoxidzellen erreicht werden.

Des Weiteren wird vorgeschlagen, dass das Testsystem eine Abgasleitung aufweist zu einem Abführen von Abgas von der zumindest einen Teststation und der zumindest einen weiteren Teststation, wobei die zumindest eine Abgasleitung zumindest abschnittsweise in zumindest einer von der Testschicht verschiedenen Stapelschicht der zumindest drei Stapelschichten angeordnet ist. Vorzugsweise ist die zumindest eine Abgasleitung zumindest abschnittsweise in der zumindest einen Mischschicht angeordnet. Vorzugsweise ist die zumindest eine Abgasleitung zumindest abschnittsweise in der zumindest einen Hydrationsschicht angeordnet. Vorzugsweise erstreckt sich die zumindest eine Abgasleitung durch die zumindest eine Mischschicht, insbesondere entlang der Stapelrichtung. Vorzugsweise erstreckt sich die zumindest eine Abgasleitung durch die zumindest eine Hydrationsschicht, insbesondere entlang der Stapelrichtung. Bevorzugt ist die zumindest eine Abgasleitung beabstandet von der zumindest einen Testschicht angeordnet. Bevorzugt ist die zumindest eine Abgasleitung beabstandet von der Mischkammer in der Mischschicht angeordnet. Bevorzugt ist die zumindest eine Abgasleitung beabstandet von der Reaktionskammer in der Hydrationsschicht angeordnet. Bevorzugt ist die zumindest eine Abgasleitung dazu ausgebildet, Abgas von der zumindest einen Teststation und von der zumindest einen weiteren Teststation abzuführen. Es kann eine vorteilhaft gleichmäßig temperierte Abgasleitung erreicht werden. Insbesondere können Risiken von unvorteilhaften Abgasströmungen vorteilhaft reduziert werden. Es können vorteilhaft gleichmäßige Testbedingungen für alle Teststationen erreicht werden. Es können Rekondensationseffekte vorteilhaft verringert werden.

Ferner wird vorgeschlagen, dass die zumindest eine Teststation und die zumindest eine weitere Teststation zumindest in Bezug auf einen Gasweg von der Mischkammer zu den jeweiligen Teststationen gleich weit von der Mischkammer beabstandet angeordnet sind. Vorzugsweise sind alle Teststationen gleich weit von der Mischkammer entfernt angeordnet in Bezug auf einen Gasweg von der Mischkammer zu den jeweiligen Teststationen. Vorzugsweise sind alle Teststationen symmetrisch zueinander an der Testschicht um einen Gasausgang aus der Mischkammer herum angeordnet. Bevorzugt weist die Mischkammer den Gasausgang auf. Bevorzugt ist der Gasausgang zentral an einer der Testschicht zugewandten Außenseite der Mischkammer angeordnet. Bevorzugt ist ein Gasweg von der Mischkammer, insbesondere von dem Gasausgang der Mischkammer, bis zu jeder Teststation gleich lang ausgebildet. Bevorzugt ist ein Gasweg von der Mischkammer, insbesondere von dem Gasausgang der Mischkammer, bis zu jeder Teststation gleich geformt ausgebildet. Es kann ein vorteilhaft einheitliches Versorgen der Teststationen mit dem einheitlichen Gasgemisch erreicht werden.

Des Weiteren wird vorgeschlagen, dass die Gaskontrolleinheit zumindest eine, bevorzugt zumindest zwei, zusätzliche Teststationen, welche an der Testschicht angeordnet ist, aufweist. □Bevorzugt sind alle Teststationen gleich, insbesondere geformt, ausgebildet. Bevorzugt ist die zumindest eine Teststation analog zu der zumindest einen weiteren Teststation ausgebildet. Bevorzugt ist die zumindest eine zusätzliche Teststation analog zu der zumindest einen Teststation und/oder zu der zumindest einen weiteren Teststation ausgebildet. Bevorzugt weist jede Teststation einen Gaseingang auf, welcher in Bezug auf einen Gasweg von der Mischkammer, gleich weit von der zumindest einen Mischkammer, insbesondere von dem Gasausgang der zumindest einen Mischkammer, entfernt angeordnet ist. Es kann ein vorteilhaft kostengünstiges Charakterisieren von Festoxidzellen erreicht werden. Es können vorteilhafte belastbare Statistiken aus Messungen zu Festoxidzellen erreicht werden.

Ferner wird vorgeschlagen, dass die Gaskontrolleinheit zumindest eine weitere Stapelschicht, insbesondere eine Zugasverteilschicht, aufweist, welche zwischen der Mischschicht und der Testschicht angeordnet ist und welche eine Zugasleitung begrenzt, welche die zumindest eine Teststation und die zumindest eine weitere Teststation zumindest in Bezug auf einen Gasweg äquidistant mit der zumindest eine Mischkammer verbindet. Vorzugsweise ist die zumindest eine Zugasverteilschicht zwischen der zumindest einen Mischschicht und der zumindest einen Testschicht angeordnet. Bevorzugt ist die zumindest eine Zugasverteilschicht direkt angrenzend an die Mischschicht angeordnet. Bevorzugt ist die zumindest eine Zugasverteilschicht von der Testschicht um zumindest eine Stapelschicht, insbesondere eine Abgaskollektorschicht, beabstandet angeordnet. Die zumindest eine Zugasverteilschicht kann direkt angrenzend an die zumindest eine Testschicht angeordnet sein. Die zumindest eine Zugasverteilschicht kann von der Mischschicht um zumindest eine Stapelschicht, insbesondere eine Abgaskollektorschicht, beabstandet angeordnet sein. Vorzugsweise ist der Gasausgang der Mischkammer mit der Zugasverteilschicht, insbesondere mit der Zugasleitung gasleitend verbunden. Vorzugsweise ist die Zugasleitung auf eine symmetrische Form um eine zentrale Zugaskonnektorausnehmung ausgebildet zu einem gleichmäßigen Verbinden der Teststationen mit der Mischkammer in Bezug auf den Gasweg von der Mischkammer zu den Teststationen. Bevorzugt ist die Zugasleitung an der Zugaskonnektorausnehmung mit der Mischkammer verbunden, insbesondere durch eine gerade Gasleitung. Es kann eine vorteilhaft gleichmäßige Versorgung der Teststationen mit dem einheitlichen Brenngasgemisch erreicht werden. Insbesondere kann eine vorteilhaft einheitliche Temperierung des einheitlichen Gasgemischs in der Zugasverteilschicht erreicht werden.

Des Weiteren wird vorgeschlagen, dass die Gaskontrolleinheit zumindest eine weitere Stapelschicht, insbesondere eine, insbesondere die bereits genannte, Abgaskollektorschicht, aufweist, welche zwischen der Mischschicht und der Testschicht angeordnet ist und welche eine Abgasteilleitung begrenzt, welche die zumindest eine Teststation und die zumindest eine weitere Teststation zumindest in Bezug auf einen Gasweg äquidistant mit der zumindest einen Abgasleitung verbindet. Vorzugsweise ist die zumindest eine Abgaskollektorschicht zwischen der zumindest einen Mischschicht und der zumindest einen Testschicht angeordnet. Bevorzugt ist die zumindest eine Abgaskollektorschicht direkt angrenzend an die Testschicht angeordnet. Bevorzugt ist die zumindest eine Abgaskollektorschicht von der Mischschicht um zumindest eine Stapelschicht, insbesondere die zumindest eine Zugasverteilschicht, beabstandet angeordnet. Die zumindest eine Abgaskollektorschicht kann direkt angrenzend an die zumindest eine Mischschicht angeordnet sein. Die zumindest eine Abgaskollektorschicht kann von der Testschicht um zumindest eine Stapelschicht, insbesondere die zumindest eine Zugasverteilschicht, beabstandet angeordnet sein. Vorzugsweise ist die zumindest eine Abgasleitung mit der Abgaskollektorschicht, insbesondere mit der Abgasteilleitung gasleitend verbunden. Vorzugsweise ist die Abgasteilleitung auf eine symmetrische Form um eine zentrale Abgaskonnektorausnehmung ausgebildet zu einem gleichmäßigen Verbinden der Teststationen mit der Abgasleitung in Bezug auf den Gasweg und/oder einen effektiven Gasweg, insbesondere eine Kombination aus Länge des Gaswegs und Geometrie des Gaswegs, von den Teststationen zu der Abgasleitung. Bevorzugt ist die Abgasteilleitung an von der Abgaskonnektorausnehmung beabstandeten Abgasausnehmungen mit den Teststationen verbunden, insbesondere durch eine gerade Gasleitung. Es kann ein vorteilhaft gleichmäßiges Abführen von Abgas von den Teststationen erreicht werden. Insbesondere kann eine vorteilhaft einheitliche Temperierung des Abgases erreicht werden, wodurch insbesondere Rückstaueffekte vorteilhaft reduziert werden können.

Ferner wird vorgeschlagen, dass die Gaskontrolleinheit zumindest eine weitere Stapelschicht, insbesondere eine Gasverteilschicht, aufweist, welche zwischen der Mischschicht und der Testschicht angeordnet ist und welche eine Zugasleitung begrenzt, welche die zumindest eine Teststation und die zumindest eine weitere Teststation zumindest in Bezug auf einen Gasweg äquidistant mit der zumindest einen Mischkammer verbindet und welche eine Abgasteilleitung begrenzt, welche die zumindest eine Teststation und die zumindest eine weitere Teststation zumindest in Bezug auf einen Gasweg äquidistant mit der zumindest einen Abgasleitung verbindet. Bevorzugt ist die Gasverteilschicht als eine einstückige Variante der Abgaskollektorschicht mit der Zugasverteilschicht ausgebildet. Unter "einstückig" soll insbesondere in einem Stück geformt verstanden werden, wobei das eine Stück bevorzugt aus einem einzelnen Rohling, einer Masse und/oder einem Guss, bevorzugt aus einem einzelnen Vollmaterial in einem Fräsverfahren und/oder Sinterverfahren, hergestellt ist. Die Zugasleitung kann auf einer anderen Höhe, insbesondere in Bezug auf die Stapelrichtung, durch die Gasverteilschicht begrenzt sein als die Abgasteilleitung. Die Zugasleitung kann auf der gleichen Höhe, insbesondere in Bezug auf die Stapelrichtung, durch die Gasverteilschicht begrenzt sein als die Abgasteilleitung. Bevorzugt sind die Zugasleitung und die Abgasleitung durch zumindest 5 mm Material der Gasverteilschicht voneinander beabstandet angeordnet. Die Zugasverteilschicht und/oder die Abgaskollektorschicht können einstückig mit der Testschicht ausgebildet sein. Es kann eine vorteilhaft kostengünstige Gaskontrolleinheit erreicht werden. Insbesondere kann eine vorteilhaft kompakte Gaskontrolleinheit erreicht werden.

Ferner wird vorgeschlagen, dass das Testsystem zumindest eine Luftgemischleitung aufweist zu einer Versorgung der zumindest einen Teststation und der zumindest einen weiteren Teststation mit einem Luftgemisch, welche zumindest eine Commonraileinheit aufweist zu einem einheitlichen Versorgen der zumindest einen Teststation und der zumindest einen weiteren Teststation mit dem Luftgemisch. Bevorzugt ist die Luftgemischleitung vollständig außerhalb der Gaskontrolleinheit angeordnet. Vorzugsweise ist das Luftgemisch auf einem Druck von mindestens 1,5 bar. Vorzugsweise ist das Luftgemisch auf einem Druck zwischen 1,5 bar bis 5 bar.

Die Commonraileinheit weist vorzugsweise zumindest eine Hochdruckpumpe auf. Die Hochdruckpumpe kann aktiv auf einen Druckgeregelt sein. Zur Druckregelung bei ungeregelten Pumpen kann die Commonraileinheit zumindest ein Druckregelventil aufweisen. Vorzugsweise ist das Luftgemisch als ein Gemisch von zumindest Stickstoff und zumindest Sauerstoff ausgebildet. Es kann eine vorteilhaft einheitliche Luftgemischversorgung der Teststationen erreicht werden, insbesondere für eine Kathodenversorgung der Festoxidzellen.

Darüber hinaus wird eine Luftgemischleitung eines erfindungsgemäßen Testsystems vorgeschlagen. Es kann eine vorteilhafte Kompatibilität von Luftgemischleitung zu Gaskontrolleinheit erreicht werden. Insbesondere kann eine vorteilhafte Austauschbarkeit von Luftgemischleitungen erreicht werden.

Ausgehend von einem Testsystem zu einem Charakterisieren von Festoxidzellen, bevorzugt bei Temperaturen ab 500°C bis 850°C, mit zumindest einer Gaskontrolleinheit zu einem Ausbilden eines einheitlichen Brenngasgemischs für die Festoxidzellen, mit zumindest einer Brenngasgemischleitung, mit zumindest einer Wasserstoffgasleitung und mit zumindest einer Sauerstoffgasleitung, wobei die zumindest eine Gaskontrolleinheit zumindest drei Stapelschichten, zumindest eine Hydrationseinheit, die zu einer Befeuchtung des einheitlichen Gasgemischs direkt gasleitend mit der zumindest einen Wasserstoffgasleitung und/oder mit der zumindest einen Sauerstoffgasleitung verbunden ist und die in einer Hydrationsschicht der zumindest drei Stapelschichten angeordnet ist, zumindest eine direkt gasleitend mit der Brenngasgemischleitung und der Hydrationseinheit verbundene Mischkammer, die zu einem Ausbilden des einheitlichen Gasgemischs ausgebildet ist und die in einer Mischschicht der zumindest drei Stapelschichten angeordnet ist, und zumindest eine Teststation für eine Festoxidzelle, welche an einer Testschicht der zumindest drei Stapelschichten angeordnet ist, aufweist, wird zudem vorgeschlagen, dass die zumindest eine Hydrationseinheit eine Reaktionskammer zu einer Reaktion von Wasserstoff und Sauerstoff und zumindest einen Katalysator, bevorzugt Edelmetallkatalysator, aufweist, welche in Bezug auf einen Gasfluss vor der zumindest einen Mischkammer angeordnet ist, und welche direkt gasleitend mit der zumindest einen Wasserstoffgasleitung und mit der zumindest einen Sauerstoffgasleitung verbunden ist. Bevorzugt ist das Testsystem zu einem Charakterisieren von Festoxidzellen in einer Temperaturspanne von 500°C bis 850°C ausgebildet.

Bevorzugt ist der Katalysator als Platinkatalysator, insbesondere in der Form zumindest eines Gitters, ausgebildet. Bevorzugt ist der Katalysator zumindest teilweise, bevorzugt zumindest zum Großteil, aus Platin ausgebildet.

Durch die erfindungsgemäße Ausgestaltung des Testsystems kann ein vorteilhaft gleichmäßiges Brenngasgemisch erreicht werden zu einem gleichmäßigen Charakterisieren von Festoxidzellen unter gleichen Bedingungen. Insbesondere kann ein vorteilhaft einheitlich befeuchtetes Brenngasgemisch erreicht werden. Insbesondere kann ein Risiko eines Verkokens, insbesondere der Gaskontrolleinheit, reduziert werden.

Des Weiteren wird vorgeschlagen, dass das Testsystem eine Abgasleitung aufweist zu einem Abführen von Abgas von der zumindest einen Teststation, wobei die zumindest eine Abgasleitung zumindest abschnittsweise in zumindest einer von der Testschicht verschiedenen Stapelschicht der zumindest drei Stapelschichten angeordnet ist. Die zumindest eine Abgasleitung kann gleich wie die bereits genannte Abgasleitung sein. Bevorzugt ist die zumindest eine Abgasleitung dazu ausgebildet, Abgas zumindest von der zumindest einen Teststation abzuführen. Es kann eine vorteilhaft gleichmäßig temperierte Abgasleitung erreicht werden. Insbesondere können Risiken von unvorteilhaften Abgasströmungen vorteilhaft reduziert werden. Es können vorteilhaft gleichmäßige Testbedingungen für alle Teststationen erreicht werden.

Darüber hinaus wird eine Gaskontrolleinheit eines erfindungsgemäßen Testsystems vorgeschlagen. Es kann eine verbesserte Verfügbarkeit von Gaskontrolleinheit erreicht werden, insbesondere zur Messung von mehreren Festoxidzellen simultan. Es kann eine vorteilhaft kurze Produktionszeit, insbesondere Lieferzeit, von Gaskontrolleinheit erreicht werden, insbesondere zur Messung von mehreren Festoxidzellen simultan. Es können vorteilhaft vereinheitlichte Gaskontrolleinheiten erreicht werden, welche insbesondere vorteilhaft vergleichbare Messbedingungen erreichbar machen. Es können vorteilhaft standardisierte Messbedingungen erreicht werden. Insbesondere können vorteilhaft belastbare, insbesondere vergleichbare, Datensätze von verschiedenen Gaskontrolleinheiten erreicht werden. Es kann ein vorteilhaft hoher Sicherheitsstandard für Gaskontrolleinheiten erreicht werden.

Das/Die erfindungsgemäße/n Testsystem/e, die erfindungsgemäße Luftgemischleitung und/oder die erfindungsgemäße Gaskontrolleinheit sollen/soll hierbei nicht auf die oben beschriebene Anwendung und Ausführungsform beschränkt sein. Insbesondere können/kann das erfindungsgemäße Testsystem, die erfindungsgemäße Luftgemischleitung und/oder die erfindungsgemäße Gaskontrolleinheit zu einer Erfüllung einer hierin beschriebenen Funktionsweise eine von einer hierin genannten Anzahl von einzelnen Elementen, Bauteilen und Einheiten abweichende Anzahl aufweisen. Zudem sollen bei den in dieser Offenbarung angegebenen Wertebereichen auch innerhalb der genannten Grenzen liegende Werte als offenbart und als beliebig einsetzbar gelten.

### Zeichnung

Weitere Vorteile ergeben sich aus der folgenden Zeichnungsbeschreibung. In der Zeichnung sind zwei Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein erfindungsgemäßes Testsystem mit einer erfindungsgemäßen Gaskontrolleinheit und einer erfindungsgemäßen Luftgemischleitung in einer schematischen Darstellung,
- Fig. 2: die erfindungsgemäße Gaskontrolleinheit in einer schematischen teiltransparenten Darstellung,
- Fig. 3: einen Teil der erfindungsgemäßen Gaskontrolleinheit in einer schematischen Darstellung,
- Fig. 4: einen Teil der erfindungsgemäßen Gaskontrolleinheit in einer schematischen Darstellung,
- Fig. 5: einen Teil der erfindungsgemäßen Gaskontrolleinheit in einer schematischen Darstellung,
- Fig. 6: die erfindungsgemäße Luftgemischleitung in einer schematischen Darstellung und
- Fig. 7: einen Teil einer alternativen erfindungsgemäßen Gaskontrolleinheit eines alternativen Testsystems in einer schematischen Darstellung.

### Beschreibung der Ausführungsbeispiele

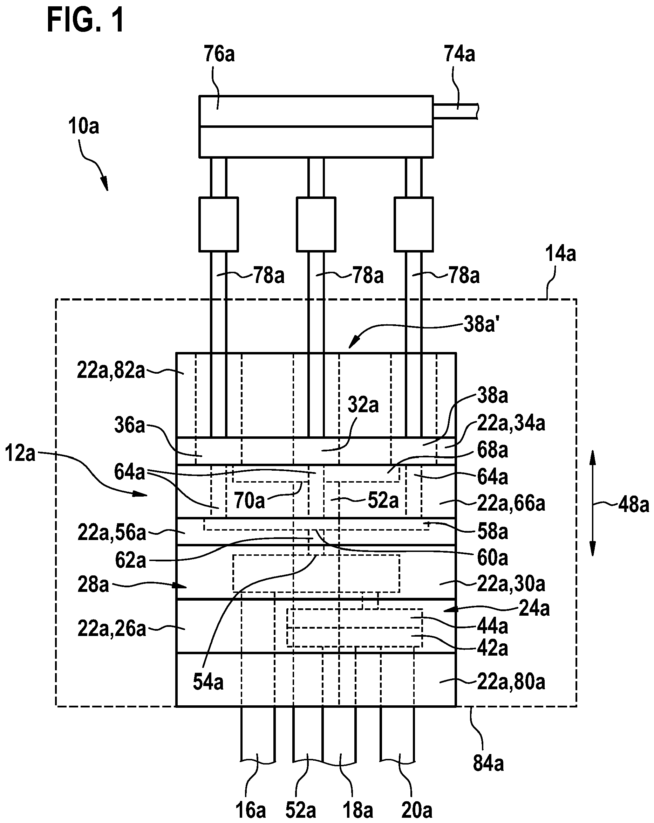

Figur 1 zeigt ein Testsystem 10a. Das Testsystem 10a ist zu einem Charakterisieren von Festoxidzellen ausgebildet. Das Testsystem 10a ist zu einem Charakterisieren von Festoxidzellen bei Temperaturen ab 500°C bis 850°C ausgebildet. Das Testsystem 10a kann zu einem Charakterisieren von Festoxidzellen bei Temperaturen ab 650°C bis 850°C ausgebildet sein, insbesondere frei von einem Katalysator 44a.

Das Testsystem 10a weist eine Gaskontrolleinheit 12a auf. Die Gaskontrolleinheit 12a ist zu einem Ausbilden eines einheitlichen Brenngasgemischs für die Festoxidzellen ausgebildet. Das Testsystem 10a weist einen Ofen 14a auf. Die Gaskontrolleinheit 12a ist in dem Ofen 14a angeordnet. Das Testsystem 10a weist eine Brenngasgemischleitung 16a auf. Das Testsystem 10a weist eine Wasserstoffgasleitung 18a auf. Das Testsystem 10a weist eine Sauerstoffgasleitung 20a auf.

Die Gaskontrolleinheit 12a umfasst hier beispielhaft sieben Stapelschichten 22a. Die Gaskontrolleinheit 12a umfasst eine Hydrationseinheit 24a. Die Hydrationseinheit 24a ist zu einer Befeuchtung des einheitlichen Gasgemischs ausgebildet. Die Hydrationseinheit 24a ist in diesem Beispiel direkt gasleitend mit der zumindest einen Wasserstoffgasleitung 18a und mit der zumindest einen Sauerstoffgasleitung 20a verbunden. Die Hydrationseinheit 24a ist in einer Hydrationsschicht 26a der sieben Stapelschichten 22a angeordnet.

Die Gaskontrolleinheit 12a umfasst eine Mischkammer 28a. Die Mischkammer 28a ist direkt gasleitend mit der Brenngasgemischleitung 16a verbunden. Die Mischkammer 28a ist direkt gasleitend mit der Hydrationseinheit 24a verbunden. Die Mischkammer 28a ist zu einem Ausbilden des einheitlichen Gasgemischs ausgebildet. Die Mischkammer 28a ist in einer Mischschicht 30a der sieben Stapelschichten 22a angeordnet.

Die Gaskontrolleinheit 12a umfasst eine Teststation 32a, 36a, 38a, 38'a. Die Teststation 32a, 36a, 38a, 38'a ist für eine Festoxidzelle ausgebildet. Die Teststation 32a, 36a, 38a, 38'a ist an einer Testschicht 34a der sieben Stapelschichten 22a angeordnet.

Die Gaskontrolleinheit 12a umfasst zumindest eine weitere Teststation 32a, 36a, 38a, 38'a. Die weitere Teststation 32a, 36a, 38a, 38a' ist für eine Festoxidzelle ausgebildet. Die weitere Teststation 32a, 36a, 38a, 38a' ist an der Testschicht 34a der sieben Stapelschichten 22a angeordnet. Die Gaskontrolleinheit 12a umfasst zwei zusätzliche Teststationen 32a, 36a, 38a, 38'a. Die zusätzlichen Teststationen 32a, 36a, 38a, 38'a sind für jeweils eine Festoxidzelle ausgebildet. Die zusätzlichen Teststationen 32a, 36a, 38a, 38'a sind an der Testschicht 34a der sieben Stapelschichten 22a angeordnet. Alle Teststationen 32a, 36a, 38a, 38a' sind gleich, insbesondere geformt, ausgebildet. Die Teststation 32a, 36a, 38a, 38a' ist analog zu der weiteren Teststation 32a, 36a, 38a, 38a' ausgebildet. Die zusätzlichen Teststationen 38a, 38'a sind analog zu der Teststation 32a, 36a, 38a, 38a' und zu der weiteren Teststation 32a, 36a, 38a, 38a' ausgebildet.

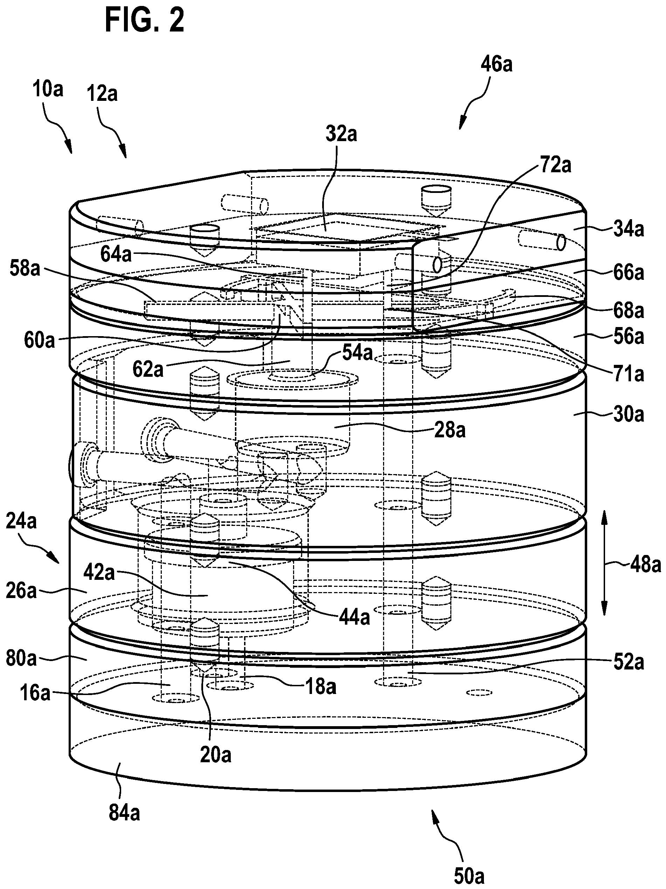

Jede Teststation 32a, 36a, 38a, 38'a weist einen Gaseingang 40a auf (vgl. Fig. 2). Die Gaseingänge 40a sind in Bezug auf einen Gasweg von der Mischkammer 28a, gleich weit von der zumindest einen Mischkammer 28a, insbesondere von einem Gasausgang 54a der Mischkammer 28a, entfernt angeordnet. Jede Teststation 32a, 36a, 38a, 38'a weist einen Gasausgang 41a auf

Das Testsystem 10a ist zu einem gleichzeitigen und zeitlich versetzten Charakterisieren von gleichartigen und von verschiedenartigen Festoxidzellen ausgebildet.

Einzelne oder alle der Festoxidzellen können dabei beispielsweise als anodengestützte, metallgestützte, kathodengestützte und/oder elektrolytgestützte Festoxidzellen ausgebildet sein. Das Testsystem 10a ist zu einem Charakterisieren von bis zu vier Festoxidzellen gleichzeitig ausgebildet. Eine Festoxidzelle kann beispielsweise als Festoxidbrennstoffzelle oder Festoxidelektrolysezelle ausgebildet sein.

Das Testsystem 10a ist zu einem Charakterisieren von Festoxidzellen in einer Temperaturspanne von 500°C bis 850°C ausgebildet.

Die Brenngasgemischleitung 16a ist zu einem Zuführen von einem Brenngasgemisch mit zumindest Kohlenstoffmonoxid-, zumindest Kohlenstoffdioxid- und zumindest Methan-Anteilen zu der Gaskontrolleinheit 12a, insbesondere zu der Mischkammer 28a, ausgebildet. Die Wasserstoffgasleitung 18a zu einem Zuführen von Wasserstoff zu der Gaskontrolleinheit 12a, insbesondere zu der Hydrationseinheit 24a, ausgebildet. Die Sauerstoffgasleitung 20a ist zu einem Zuführen von Sauerstoff zu der Gaskontrolleinheit 12a, insbesondere zu der Hydrationseinheit 24a, ausgebildet.

Die Gaskontrolleinheit 12a ist aus einer Keramik, bevorzugt einer Vollkeramik, insbesondere einer Oxidkeramik, wie beispielsweise Aluminiumoxid ausgebildet. Insbesondere sind die Stapelschichten 22a der Gaskontrolleinheit 12a bevorzugt aus der Keramik, insbesondere der Oxidkeramik, wie beispielsweise Aluminiumoxid ausgebildet.

Die Hydrationseinheit 24a weist eine Reaktionskammer 42a auf, insbesondere zu einer Reaktion von Wasserstoff und Sauerstoff. Die Reaktionskammer 42a ist direkt gasleitend mit der zumindest einen Wasserstoffgasleitung 18a und mit der zumindest einen Sauerstoffgasleitung 20a verbunden.

Bevorzugt ist die Hydrationseinheit 24a, insbesondere die Reaktionskammer 42a, direkt gasleitend mit der Mischkammer 28a verbunden, insbesondere an einer anderen Seite als die zumindest eine Wasserstoffgasleitung 18a und/oder die zumindest einen Sauerstoffgasleitung 20a mit der Hydrationseinheit 24a, insbesondere der Reaktionskammer 42a, verbunden ist/sind.

Die Hydrationseinheit 24a umfasst einen Katalysator 44a, insbesondere einen Edelmetallkatalysator. Der Katalysator 44a ist in der Reaktionskammer 42a angeordnet zu einem Katalysieren der Reaktion von Wasserstoff und Sauerstoff. Die Hydrationseinheit 24a ist in der Gaskontrolleinheit 12a angeordnet. Die Hydrationseinheit 24a ist in einer genau Stapelschicht 22a, insbesondere in der Hydrationsschicht 26a, der Gaskontrolleinheit 12a angeordnet. Der Katalysator 44a ist als Platinkatalysator, insbesondere in der Form zumindest eines Gitters, ausgebildet. Die Hydrationsschicht 26a ist verschieden von der Mischschicht 30a ausgebildet. Die Hydrationsschicht 26a ist verschieden von der Testschicht 34a ausgebildet. Die Hydrationsschicht 26a und die Mischschicht 30a sind direkt benachbarte Stapelschichten 22a der Gaskontrolleinheit 12a. Die Hydrationsschicht 26a ist auf einer der Testschicht 34a abgewandten Seite der Mischschicht 30a angeordnet.

Die Testschicht 34a ist eine vorletzte Schicht der Gaskontrolleinheit 12a in Stapelrichtung 48a, insbesondere auf einer Testseite 46a der Mischschicht 30a. Die Stapelrichtung 48a ist senkrecht zu größten Außenflächen der einzelnen Stapelschichten 22a ausgerichtet. Die Hydrationsschicht 26a ist eine vorletzte Schicht der Gaskontrolleinheit 12a in Stapelrichtung 48a, insbesondere auf einer Hydrationsseite 50a der Mischschicht 30a. Die Testschicht 34a und die Mischschicht 30a sind durch mindestens eine Stapelschicht 22a voneinander beabstandet angeordnet.

Die Hydrationsseite 50a der Mischschicht 30a ist eine der Wasserstoffgasleitung 18a, der Brenngasgemischleitung 16a und der Sauerstoffgasleitung 20a zugewandte Seite der Mischschicht 30a. Die Testseite 46a der Mischschicht 30a ist eine der Wasserstoffgasleitung 18a, der Brenngasgemischleitung 16a und der Sauerstoffgasleitung 20a abgewandte Seite der Mischschicht 30a. Die Mischschicht 30a ist zwischen der Hydrationsschicht 26a und der Testschicht 34a angeordnet.

Die Hydrationseinheit 24a ist in Bezug auf einen Gasfluss von der Brenngasgemischleitung 16a, der Wasserstoffgasleitung 18a und der Sauerstoffgasleitung 20a zu der Mischkammer 28a vor der Mischkammer 28a angeordnet.

Die Hydrationseinheit 24a ist in Bezug auf einen Gasfluss von der Brenngasgemischleitung 16a, der Wasserstoffgasleitung 18a und der Sauerstoffgasleitung 20a zu der Mischkammer 28a mit der Wasserstoffgasleitung 18a und der Sauerstoffgasleitung 20a verbunden.

Jeweils benachbarte Stapelschichten 22a sind miteinander verbunden. Einzelne Stapelschichten 22a sind durch mindestens 100 µm, insbesondere maximal 500 µm, starke Goldstreifen 88a, insbesondere innerhalb eines durch die Goldstreifen 88a definierten Dichtungsbereichs 86a gasdicht, miteinander verbunden. Einzelne Stapelschichten 22a sind durch mindestens 2 mm breite Goldstreifen 88a, insbesondere innerhalb eines durch die Goldstreifen 88a definierten Dichtungsbereichs 86a gasdicht, miteinander verbunden.

Das Testsystem 10a weist eine Abgasleitung 52a auf zu einem Abführen von Abgas von der Teststation 32a, 36a, 38a, 38a', der weiteren Teststation 32a, 36a, 38a, 38a' und den zusätzlichen Teststationen 32a, 36a, 38a, 38a' (vgl. Fig. 2). Die Abgasleitung 52a ist abschnittsweise in mindestens einer von der Testschicht 34a verschiedenen Stapelschicht 22a der sieben Stapelschichten 22a angeordnet. Die Abgasleitung 52a ist abschnittsweise in der Mischschicht 30a angeordnet.

Die Abgasleitung 52a ist abschnittsweise in der zumindest einen Hydrationsschicht 26a angeordnet. Die Abgasleitung 52a erstreckt sich durch die Mischschicht 30a, insbesondere entlang der Stapelrichtung 48a. Die Abgasleitung 52a erstreckt sich durch die zumindest eine Hydrationsschicht 26a, insbesondere entlang der Stapelrichtung 48a. Die Abgasleitung 52a ist beabstandet von der zumindest einen Testschicht 34a angeordnet. Die Abgasleitung 52a ist beabstandet von der Mischkammer 28a in der Mischschicht 30a angeordnet.

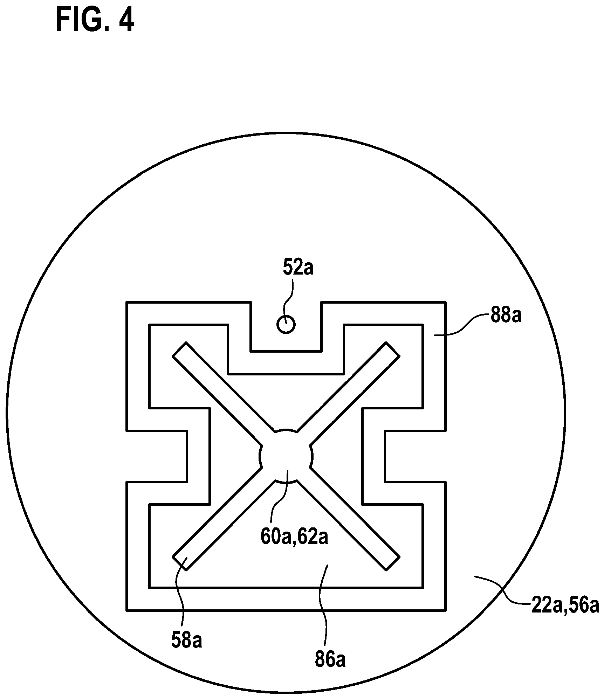

Die Abgasleitung 52a ist beabstandet von der Reaktionskammer 42a in der Hydrationsschicht 26a angeordnet. Die Abgasleitung 52a ist dazu ausgebildet, Abgas von der Teststation 32a, 36a, 38a, 38a', von der weiteren Teststation 32a, 36a, 38a, 38a' und von den zusätzlichen Teststationen 32a, 36a, 38a, 38a' abzuführen. Die Teststation 32a, 36a, 38a, 38a', die weitere Teststation 32a, 36a, 38a, 38a' und die zusätzlichen Teststationen 32a, 36a, 38a, 38a' sind in Bezug auf einen Gasweg von der Mischkammer 28a zu den jeweiligen Teststationen 32a, 36a, 38a, 38'a gleich weit von der Mischkammer 28a beabstandet angeordnet. Alle Teststationen 32a, 36a, 38a, 38'a sind gleich weit von der Mischkammer 28a entfernt angeordnet in Bezug auf einen Gasweg von der Mischkammer 28a zu den jeweiligen Teststationen 32a, 36a, 38a, 38'a. Alle Teststationen 32a, 36a, 38a, 38'a sind symmetrisch zueinander an der Testschicht 34a um einen Gasausgang 54a aus der Mischkammer 28a herum angeordnet. Bevorzugt weist die Mischkammer 28a den Gasausgang 54a auf. Der Gasausgang 54a ist zentral an einer der Testschicht 34a zugewandten Außenseite der Mischkammer 28a angeordnet. Ein Gasweg von der Mischkammer 28a, insbesondere von dem Gasausgang 54a der Mischkammer 28a, bis zu jeder Teststation 32a, 36a, 38a, 38'a ist gleich lang ausgebildet. Der Gasweg von der Mischkammer 28a, insbesondere von dem Gasausgang 54a der Mischkammer 28a, bis zu jeder Teststation 32a, 36a, 38a, 38'a ist gleich geformt ausgebildet (vgl. Fig. 4).

Die Gaskontrolleinheit 12a weist zumindest eine weitere Stapelschicht 22a, insbesondere eine Zugasverteilschicht 56a, auf (vgl. Fig. 4). Die Zugasverteilschicht 56a ist zwischen der Mischschicht 30a und der Testschicht 34a angeordnet. Die Zugasverteilschicht 56a begrenzt eine Zugasleitung 58a. Die Zugasleitung 58a verbindet die Teststationen 32a, 36a, 38a, 38'a in Bezug auf einen Gasweg äquidistant mit der zumindest einen Mischkammer 28a.

Die Zugasverteilschicht 56a ist direkt angrenzend an die Mischschicht 30a angeordnet. Die Zugasverteilschicht 56a ist von der Testschicht 34a um zumindest eine Stapelschicht 22a, insbesondere eine Abgaskollektorschicht 66a, beabstandet angeordnet. Der Gasausgang 54a der Mischkammer 28a ist mit der Zugasverteilschicht 56a, insbesondere mit der Zugasleitung 58a gasleitend verbunden. Die Zugasleitung 58a ist auf eine symmetrische Form um eine zentrale Zugaskonnektorausnehmung 60a begrenzt ausgebildet zu einem gleichmäßigen Verbinden der Teststationen 32a, 36a, 38a, 38a' mit der Mischkammer 28a in Bezug auf den Gasweg von der Mischkammer 28a zu den Teststationen 32a, 36a, 38a, 38a'. Die Zugasleitung 58a ist auf eine X-Form begrenzt in der Zugasverteilschicht 56a ausgebildet (vgl. Draufsicht entlang der Stapelrichtung 48a in Fig. 4).

Die Zugasleitung 58a ist an der Zugaskonnektorausnehmung 60a mit der Mischkammer 28a verbunden, insbesondere durch eine gerade, in Stapelrichtung 48a verlaufende, Gasleitung 62a. Die Zugasleitung 58a ist an von der Zugaskonnektorausnehmung 60a beabstandeten Enden mit jeweils einer Teststation 32a, 36a, 38a, 38'a verbunden, insbesondere durch eine gerade, in Stapelrichtung 48a verlaufende, Gasleitung 64a. Die Zugasleitung 58a ist in der Zugasverteilschicht 56a in eine Stapelrichtung 48a unbegrenzt ausgebildet. Die Zugasleitung 58a ist in der Zugasverteilschicht 56a in eine Stapelrichtung 48a mindestens zu 95% begrenzt ausgebildet.

Die Gaskontrolleinheit 12a weist eine weitere Stapelschicht 22a, insbesondere die Abgaskollektorschicht 66a, auf. Die Abgaskollektorschicht 66a ist zwischen der Mischschicht 30a und der Testschicht 34a angeordnet. Die Abgaskollektorschicht 66a begrenzt eine Abgasteilleitung 68a. Die Abgasteilleitung 68a verbindet die Teststationen 32a, 36a, 38a, 38a' zumindest in Bezug auf einen Gasweg äquidistant mit der Abgasleitung 52a.

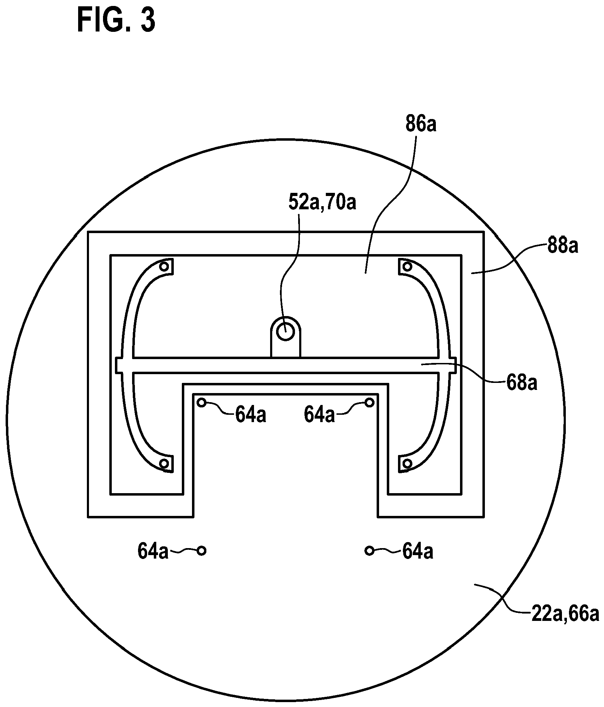

Die Abgaskollektorschicht 66a ist zwischen der Mischschicht 30a und der Testschicht 34a angeordnet. Die Abgaskollektorschicht 66a ist direkt angrenzend an die Testschicht 34a angeordnet. Die Abgaskollektorschicht 66a ist von der Mischschicht 30a um zumindest eine Stapelschicht 22a, insbesondere die zumindest eine Zugasverteilschicht 56a, beabstandet angeordnet. Die Abgasleitung 52a ist mit der Abgasteilleitung 68a gasleitend verbunden. Die Abgasteilleitung 68a ist auf eine Form um eine zentrale Abgaskonnektorausnehmung 70a ausgebildet zu einem gleichmäßigen Verbinden der Teststationen 32a, 36a, 38a, 38'a mit der Abgasleitung 52a in Bezug auf den Gasweg von den Teststationen 32a, 36a, 38a, 38'a zu der Abgasleitung 52a (vgl. Draufsicht entlang der Stapelrichtung 48a in Fig. 3). Die Abgasteilleitung 68a ist an von der Abgaskonnektorausnehmung 70a beabstandeten Abgasausnehmungen 71a mit den Teststationen 32a, 36a, 38a, 38'a verbunden, insbesondere durch eine gerade Gasleitung 72a.

Das Testsystem 10a weist eine Luftgemischleitung 74a auf (vgl. Fig. 1). Die Luftgemischleitung 74a ist zu einer Versorgung der Teststationen 32a, 36a, 38a, 38'a mit einem Luftgemisch ausgebildet. Die Luftgemischleitung 74a weist eine Commonraileinheit 76a auf. Die Commonraileinheit 76a ist zu einem einheitlichen Versorgen der Teststationen 32a, 36a, 38a, 38'a mit dem Luftgemisch. Die Luftgemischleitung 74a ist vollständig außerhalb der Gaskontrolleinheit 12a angeordnet. Das Luftgemisch ist als ein Gemisch von zumindest Stickstoff und zumindest Sauerstoff ausgebildet. Die Commonraileinheit 76a ist durch vier Gasleitungen 78a mit den einzelnen Teststationen 32a, 36a, 38a, 38'a verbunden.

Die Gaskontrolleinheit 12a weist eine Basisschicht 80a auf zu einem Verbinden eines metallischen Ofenbodens 84a mit der Gaskontrolleinheit 12a. Die Gaskontrolleinheit 12a weist eine Abdeckschicht 82a auf, zu einem Abdecken und zu einem auf einer definierten Temperatur Halten der Teststationen 32a, 36a, 38a, 38'a bei einem Testvorgang.

Die Abgasleitung 52a erstreckt sich durch die Mischschicht 30a, durch die Hydrationsschicht 26a, durch die Basisschicht 80a, durch die Zugasverteilschicht 56a, teilweise durch die Abgaskollektorschicht 66a jeweils in Stapelrichtung 48a.

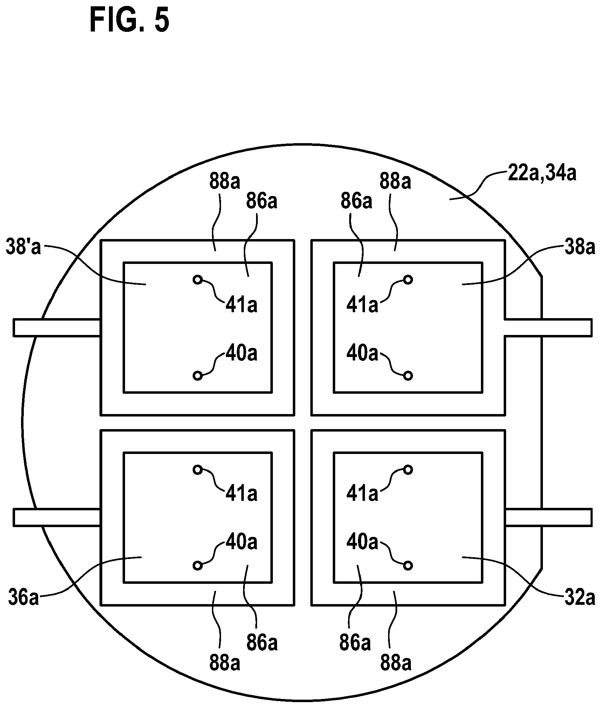

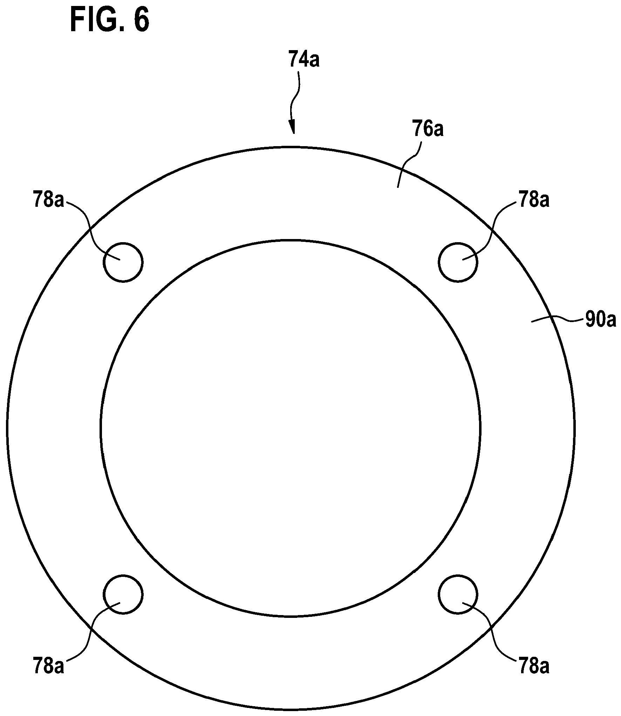

Figur 2 zeigt insbesondere die Gaskontrolleinheit 12a in einer teiltransparenten Darstellung mit lediglich einer der Teststationen 32a, 36a, 38'a, 38'a zur besseren Übersicht. Figur 3 zeigt insbesondere die Abgaskollektorschicht 66a in einer Ansicht entlang der Stapelrichtung 48a. Figur 4 zeigt insbesondere die Zugasverteilschicht 56a in einer Ansicht entlang der Stapelrichtung 48a. Insbesondere sind die Zugasverteilschicht 56a und die Abgaskollektorschicht 66a an einer offenen Seite der Abgasteilleitung 68a und der Zugasleitung 58a durch 5 mm starke Goldstreifen 88a mit der nächsten Stapelschicht 22a verbunden zu einem Ausbilden jeweils eines innerhalb durch die Goldstreifen 88a definierten gasdichten Dichtungsbereichs 86a. Figuren 3 und 4 sind schematisch und nicht einheitlich dimensioniert dargestellt und dienen lediglich zum Verständnis. Figur 5 zeigt insbesondere die Testschicht 34a in einer Ansicht entlang der Stapelrichtung 48a mit allen vier Teststationen 32a, 36a, 38a, 38'a in einer beispielhaften Anordnung. Figur 6 zeigt insbesondere die Commonraileinheit 76a in einer Ansicht entlang der Stapelrichtung 48a. Die Commonraileinheit 76a begrenzt einen äußeren Gasflussring 90a zu einem Erzeugen des einheitlichen Luftgemischs.

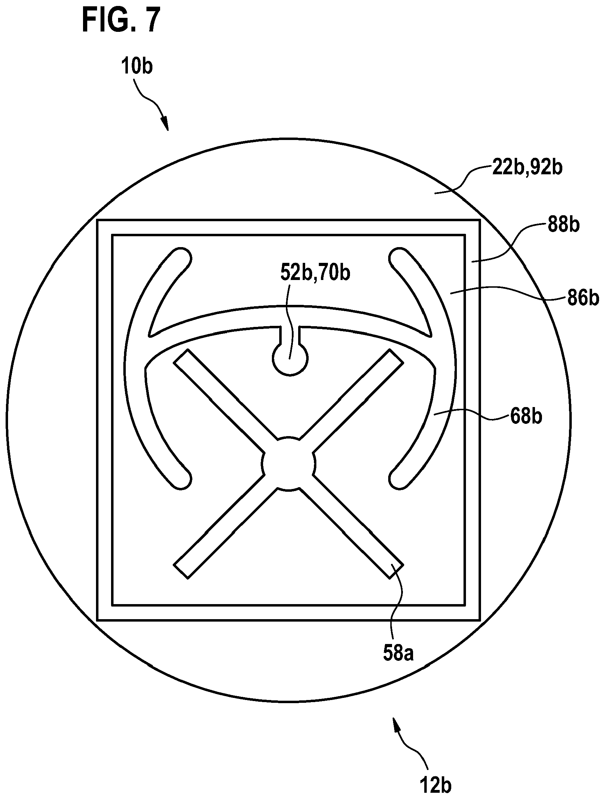

In der Figur 7 ist ein weiteres Ausführungsbeispiel der Erfindung gezeigt. Die nachfolgenden Beschreibungen und die Zeichnungen beschränken sich im Wesentlichen auf die Unterschiede zwischen den Ausführungsbeispielen, wobei bezüglich gleich bezeichneter Bauteile, insbesondere in Bezug auf Bauteile mit gleichen Bezugszeichen, grundsätzlich auch auf die Zeichnungen und/oder die Beschreibung der anderen Ausführungsbeispiele, insbesondere der Figuren 1 bis 6, verwiesen werden kann. Zur Unterscheidung der Ausführungsbeispiele ist der Buchstabe a den Bezugszeichen des Ausführungsbeispiels in den Figuren 1 bis 6 nachgestellt. In dem Ausführungsbeispiel der Figur 7 ist der Buchstabe a durch den Buchstaben b ersetzt.

Figur 7 zeigt ein alternatives Testsystem 10b. Das Testsystem 10b weist eine Gaskontrolleinheit 12b auf. Die Gaskontrolleinheit 12b weist eine Stapelschicht 22b, insbesondere eine Gasverteilschicht 92b, auf. Die Gasverteilschicht 92b ist als eine einstückige Variante der Abgaskollektorschicht 66a mit der Zugasverteilschicht 56a aus dem vorherigen Ausführungsbeispiel ausgebildet.

Die Gasverteilschicht 92b ist zwischen einer Mischschicht 30b und einer Testschicht 34b angeordnet. Die Gasverteilschicht 92b begrenzt eine Zugasleitung 58b. Die Zugasleitung 58b verbindet vier Teststationen 32b, 36b, 38b, 38b' zumindest in Bezug auf einen Gasweg äquidistant mit einer Mischkammer 28b. Die Gasverteilschicht 92b begrenzt eine Abgasteilleitung 68b.

Die Abgasteilleitung 68b verbindet die vier Teststationen 32b, 36b, 38b, 38b' in Bezug auf einen effektiven Gasweg, insbesondere einer Kombination aus Länge des Gaswegs und Geometrie des Gaswegs, von den Teststationen 32b, 36b, 38b, 38b' zu der Abgasleitung 52b äquidistant mit der Abgasleitung 52b.

Die Zugasleitung 58b ist auf der gleichen Höhe, insbesondere in Bezug auf eine Stapelrichtung 48b, durch die Gasverteilschicht 92b begrenzt wie die Abgasteilleitung 68b. Die Zugasleitung 58b und die Abgasleitung 52b sind durch zumindest 5 mm Material der Gasverteilschicht 92b voneinander beabstandet angeordnet.

Die Abgasteilleitung 68b ist auf eine symmetrische Form um eine zentrale Abgaskonnektorausnehmung 70b ausgebildet zu einem gleichmäßigen Verbinden der Teststationen 32b, 36b, 38b, 38b' mit einer Abgasleitung 52b in Bezug auf einen effektiven Gasweg, insbesondere einer Kombination aus Länge des Gaswegs und Geometrie des Gaswegs, von den Teststationen 32b, 36b, 38b, 38b' zu der Abgasleitung 52b. Figur 7 zeigt insbesondere die Gasverteilschicht 92b in einer Draufsicht entlang der Stapelrichtung 48b.

## Patentansprüche

1. Testsystem zu einem Charakterisieren von Festoxidzellen, bevorzugt bei Temperaturen ab 500°C bis 850°C, mit zumindest einer Gaskontrolleinheit (12a; 12b) zu einem Ausbilden eines einheitlichen Brenngasgemischs für die Festoxidzellen, mit zumindest einer Brenngasgemischleitung (16a; 16b), mit zumindest einer Wasserstoffgasleitung (18a; 18b), und insbesondere mit zumindest einer Sauerstoffgasleitung (20a; 20b), wobei die zumindest eine Gaskontrolleinheit (12a; 12b) zumindest drei Stapelschichten (22a; 22b), zumindest eine Hydrationseinheit (24a; 24b), die zu einer Befeuchtung des einheitlichen Gasgemischs ausgebildet ist, die insbesondere direkt gasleitend mit der zumindest einen Wasserstoffgasleitung (18a; 18b) und/oder mit der zumindest einen Sauerstoffgasleitung (20a; 20b) verbunden ist, und die in einer Hydrationsschicht (26a; 26b) der zumindest drei Stapelschichten (22a; 22b) angeordnet ist, zumindest eine direkt gasleitend mit der Brenngasgemischleitung (16a; 16b) und der Hydrationseinheit (24a; 24b) verbundene Mischkammer (28a; 28b), die zu einem Ausbilden des einheitlichen Gasgemischs ausgebildet ist und die in einer Mischschicht (30a; 30b) der zumindest drei Stapelschichten (22a; 22b) angeordnet ist, und zumindest eine Teststation (32a, 36a, 38a, 38a'; 32b, 36b, 38b, 38b') für eine Festoxidzelle, welche an einer Testschicht (34a; 34b) der zumindest drei Stapelschichten (22a; 22b) angeordnet ist, aufweist, **dadurch gekennzeichnet, dass** die Gaskontrolleinheit (12a; 12b) zumindest eine weitere Teststation (32a, 36a, 38a, 38a'; 32b, 36b, 38b, 38b') für zumindest eine weitere Festoxidzelle aufweist, welche an der Testschicht (34a; 34b) angeordnet ist.

2. Testsystem nach Anspruch 1, **gekennzeichnet durch** eine Abgasleitung (52a; 52b) zu einem Abführen von Abgas von der zumindest einen Teststation (32a, 36a, 38a, 38a'; 32b, 36b, 38b, 38b') und der zumindest einen weiteren Teststation (32a, 36a, 38a, 38a'; 32b, 36b, 38b, 38b'), wobei die zumindest eine Abgasleitung (52a; 52b) zumindest abschnittsweise in zumindest einer von der Testschicht (34a; 34b) verschiedenen Stapelschicht (22a; 22b) der zumindest drei Stapelschichten (22a; 22b) angeordnet ist.

3. Testsystem nach Anspruch 1 oder 2, **dadurch gekennzeichnet, dass** die zumindest eine Teststation (32a, 36a, 38a, 38a'; 32b, 36b, 38b, 38b') und die zumindest eine weitere Teststation (32a, 36a, 38a, 38a'; 32b, 36b, 38b, 38b') zumindest in Bezug auf einen Gasweg von der Mischkammer (28a; 28b) zu den jeweiligen Teststationen (32a, 36a, 38a, 38a'; 32b, 36b, 38b, 38b') gleich weit von der Mischkammer (28a; 28b) beabstandet angeordnet sind.

4. Testsystem nach einem der vorhergehenden Ansprüche, **dadurch gekennzeichnet, dass** die Gaskontrolleinheit (12a; 12b) zumindest eine, bevorzugt zumindest zwei, zusätzliche Teststationen (32a, 36a, 38a, 38a'; 32b, 36b, 38b, 38b'), welche an der Testschicht (34a; 34b) angeordnet ist, aufweist.

5. Testsystem nach einem der vorhergehenden Ansprüche, **dadurch gekennzeichnet, dass** die Gaskontrolleinheit (12a; 12b) zumindest eine weitere Stapelschicht (22a; 22b), insbesondere eine Zugasverteilschicht (56a; 56b), aufweist, welche zwischen der Mischschicht (30a; 30b) und der Testschicht (34a; 34b) angeordnet ist und welche eine Zugasleitung (58b) begrenzt, welche die zumindest eine Teststation (32a, 36a, 38a, 38a'; 32b, 36b, 38b, 38b') und die zumindest eine weitere Teststation (32a, 36a, 38a, 38a'; 32b, 36b, 38b, 38b') zumindest in Bezug auf einen Gasweg äquidistant mit der zumindest einen Mischkammer (28a; 28b) verbindet.

6. Testsystem zumindest nach Anspruch 2, **dadurch gekennzeichnet, dass** die Gaskontrolleinheit (12a; 12b) zumindest eine weitere Stapelschicht (22a; 22b), insbesondere eine Abgaskollektorschicht (66a; 66b), aufweist, welche zwischen der Mischschicht (30a; 30b) und der Testschicht (34a; 34b) angeordnet ist und welche eine Abgasteilleitung (68a; 68b) begrenzt, welche die zumindest eine Teststation (32a, 36a, 38a, 38a'; 32b, 36b, 38b, 38b') und die zumindest eine weitere Teststation (32a, 36a, 38a, 38a'; 32b, 36b, 38b, 38b') zumindest in Bezug auf einen Gasweg äquidistant mit der zumindest einen Abgasleitung (52a; 52b) verbindet.

7. Testsystem zumindest nach Anspruch 2, **dadurch gekennzeichnet, dass** die Gaskontrolleinheit (12b) zumindest eine weitere Stapelschicht (22b), insbesondere eine Gasverteilschicht (92b), aufweist, welche zwischen der Mischschicht (30b) und der Testschicht (34b) angeordnet ist und welche eine Zugasleitung (58b) begrenzt, welche die zumindest eine Teststation (32b, 36b, 38b, 38b') und die zumindest eine weitere Teststation (32b, 36b, 38b, 38b') zumindest in Bezug auf einen Gasweg äquidistant mit der zumindest einen Mischkammer (28b) verbindet und welche eine Abgasteilleitung (68b) begrenzt, welche die zumindest eine Teststation (32b, 36b, 38b, 38b') und die zumindest eine weitere Teststation (32b, 36b, 38b, 38b') zumindest in Bezug auf einen Gasweg äquidistant mit der zumindest einen Abgasleitung (52b) verbindet.

8. Testsystem nach einem der vorhergehenden Ansprüche, **gekennzeichnet durch** zumindest eine Luftgemischleitung (74a; 74b) zu einer Versorgung der zumindest einen Teststation (32a, 36a, 38a, 38a'; 32b, 36b, 38b, 38b') und der zumindest einen weiteren Teststation (32a, 36a, 38a, 38a'; 32b, 36b, 38b, 38b') mit einem Luftgemisch, welche zumindest eine Commonraileinheit (76a; 76b) aufweist zu einem einheitlichen Versorgen der zumindest einen Teststation (32a, 36a, 38a, 38a'; 32b, 36b, 38b, 38b') und der zumindest einen weiteren Teststation (32a, 36a, 38a, 38a'; 32b, 36b, 38b, 38b') mit dem Luftgemisch.

9. Luftgemischleitung eines Testsystems (10a; 10b) nach Anspruch 8.

10. Testsystem nach dem Oberbegriff des Anspruchs 1, insbesondere nach Anspruch 1, **dadurch gekennzeichnet, dass** die zumindest eine Hydrationseinheit (24a; 24b) eine Reaktionskammer (42a; 42b) zu einer Reaktion von Wasserstoff und Sauerstoff und zumindest einen Katalysator (44a; 44b), bevorzugt Edelmetallkatalysator, aufweist, welche in Bezug auf einen Gasfluss vor der zumindest einen Mischkammer (28a; 28b) angeordnet ist, und welche direkt gasleitend mit der zumindest einen Wasserstoffgasleitung (18a; 18b) und mit der zumindest einen Sauerstoffgasleitung (20a; 20b) verbunden ist.

11. Testsystem nach Anspruch 10, **gekennzeichnet durch** eine Abgasleitung (52a; 52b) zu einem Abführen von Abgas von der zumindest einen Teststation (32a, 36a, 38a, 38a'; 32b, 36b, 38b, 38b'), wobei die zumindest eine Abgasleitung (52a; 52b) zumindest abschnittsweise in zumindest einer von der Testschicht (34a; 34b) verschiedenen Stapelschicht (22a; 22b) der zumindest drei Stapelschichten (22a; 22b) angeordnet ist.

12. Gaskontrolleinheit (12a; 12b) eines Testsystems (10a; 10b) nach einem der vorhergehenden Ansprüche.
